# EUROPÄISCHE PATENTSCHRIFT

(11) **EP 0 630 486 B1**
(45) Veröffentlichungstag und Bekanntmachung des Hinweises auf die Patenterteilung: **25.03.1998**
(21) Anmeldenummer: 94900752.0
(22) Anmeldetag: 04.12.1993
(51) Int. Cl.: G02B 6/42, G02B 6/12

(54) **VERFAHREN ZUR HERSTELLUNG EINER HYBRID INTEGRIERTEN OPTISCHEN SCHALTUNG UND VORRICHTUNG ZUR EMISSION VON LICHTWELLEN**
PROCESS FOR PRODUCING A HYBRID INTEGRATED OPTICAL CIRCUIT AND DEVICE FOR EMITTING LIGHT WAVES
PROCEDE DE FABRICATION D'UN CIRCUIT OPTIQUE INTEGRE DE MANIERE HYBRIDE ET DISPOSITIF PERMETTANT D'EMETTRE DES ONDES LUMINEUSES

(30) Priorität: 13.01.1993 DE 4300652
(43) Veröffentlichungstag der Anmeldung: 28.12.1994
(73) Patentinhaber: ROBERT BOSCH GMBH, 70442 Stuttgart (DE)
(72) Erfinder: KRAGL, Hans, D-64372 Ober-Ramstadt (DE); RECH, Wolf-Henning, D-64347 Griesheim (DE)
(86) Internationale Anmeldenummer: DE9301155
(87) Internationale Veröffentlichungsnummer: WO9416348

(56) Entgegenhaltungen:
- EP-A- 0 313 956
- EP-A- 0 331 331
- EP-A- 0 331 338
- EP-A- 0 495 559
- WO-A-94/08263
- ECOC 92 Bd. 1 , 27. September 1992 , BERLIN Seiten 329 - 332 K.P.JACKSON ET AL. 'FLIP/CHIP,SELF-ALIGNED,OPTOELECTRONIC TRANCEIVER MODULE'
- ECOC 92 Bd. 1 , 27. September 1992 , BERLIN Seiten 537 - 540 M.HAMACHER ET AL 'A NO0VEL FIBRE/CHIP COUPLING TECHNIQUE WITH AN INTEGRATED STRAIN RELIEF ON InP'
- ELECTRONICS LETTERS Bd. 28, Nr. 16 , 30. Juli 1992 , ENAGE GB Seiten 1514 - 1515 Z.WEISSMAN ET AL '2-D MODE TAPERING VIA TAPERED CHANNEL WAVEGUIDE SEGMENTATION'
- PATENT ABSTRACTS OF JAPAN vol. 14, no. 358 (P-1087)(4301) 2. August 1990 & JP,A,02 131 202 (OMRON TATEISI ELECTRON) 21. Mai 1990
- PATENT ABSTRACTS OF JAPAN vol. 008, no. 248 (P-313)14. November 1984 & JP,A,59 121 008 (TOUKIYOU KOGYO DAIGAKU) 12. Juli 1984

## Beschreibung

### Stand der Technik

Die Erfindung geht aus von einem Verfahren zur Herstellung einer hybrid integrierten optischen Schaltung nach der Gattung des Hauptanspruches. Es ist schon ein Verfahren bekannt, bei dem eine Glasfaser an einen Wellenleiter, der in einen Indium-Phosphid-Chip eingebracht worden ist, angekoppelt wird. Um die Glasfaser justiert an den zur Kopplung präparierten Wellenleiter ankoppeln zu können, muß in den Indium-Phosphid-Chip ein V-förmiger Graben eingeätzt werden. Des weiteren ist die Justierung der Glasfaser manuell unter einem Mikroskop notwendig, damit die durch falsche Justage auftretenden Kopplungsverluste so gering wie möglich gehalten werden. (M. Hamacher, A novel fibre/chip coupling technique with an integrated strain relief on InP, ECOC 92, Berlin, S. 537 ff.) Dieses Verfahren ist zeitaufwendig, teuer und kann für eine Massenproduktion nicht angewendet werden.

Des weiteren ist ein Verfahren bekannt, bei dem ein Laserchip mit Hilfe von Abstandshaltern und Justiervorrichtungen auf einer integrierten optischen Schaltung in Bezug auf Wellenleitern justiert wird. Dieses Verfahren erfordert jedoch, daß der Laserchip mittels Ätzvorgängen zur Aufnahme der Abstandshalter und der Justiervorrichtungen strukturiert wird. Weiterhin müssen die Abstandshalter und die Begrenzungen auf die integrierte optische Schaltung aufgebracht werden. Dies ist jedoch sehr aufwendig, da die Abstanshalter und die Justiereinrichtungen mit hoher Genauigkeit hergestellt und positioniert werden müssen. Zudem muß der Laserchip manuell in die Justiereinrichtungen eingebracht werden.(Jackson, Flip/Chip, Self-Aligned, Optoelectronic Transceiver Module, ECOC 92, Berlin, S. 329 ff).

Weitere Beispiele sind aus EP-A-331 331 und WO-A-94/08263 bekannt, wobei das letztgenannte Dokument einen Stand der Technik gemäß Art. 54(3) EPÜ darstellt.

### Vorteile der Erfindung

Das erfindungsgemäße Verfahren mit den kennzeichnenden Merkmalen des Hauptanspruchs und die Vorrichtung mit den kennzeichnenden Merkmalen des Anspruchs 11 haben demgegenüber den Vorteil, daß sich die Justierung des elektrooptischen Halbleiterbauelementes auf den Wellenleiter und die Justierung des Wellenleiters auf den Lichtwellenleiter bei der Abformung der Grundeinheit, die aus dem elektrooptischen Halbleiterbauelement und dem abgeformten Polymer besteht, ohne zusätzlichen Aufwand ergibt. Dadurch wird eine zeitaufwendige manuelle Justage vermieden.

Durch die Verwendung eines Abformwerkzeuges, das einfach und preiswert in vielen Formen galvanisch hergestellt werden kann, ist die Herstellung von unterschiedlich aufgebauten integrierten optischen Schaltungen möglich. Der einfache Abformvorgang, wobei das elektrooptische Halbleiterbauelement selbstjustierend an den Wellenleitergraben angekoppelt wird, eignet sich für eine automatisierte Massenproduktion. Dadurch können integrierte optische Schaltungen preiswert hergestellt werden.

Durch die in den Unteransprüchen aufgeführten Maßnahmen sind vorteilhafte Weiterbildungen und Verbesserungen des im Hauptanspruch angegebenen Verfahrens und der im Anspruch 11 angegebenen Vorrichtung möglich.

Besonders vorteilhaft ist, daß die Seitenwände der Aufnahmevorrichtungen des Abformwerkzeuges, die den Raum für das aufzunehmende elektrooptische Halbleiterbauelement begrenzen, und die Seitenwände des elektrooptischen Halbleiterbauelementes abgeschrägt nach innen verlaufen. Dadurch gleiten die Seiten der Aufnahmevorrichtung und die des elektrooptischen Halbleiterbauelementes beim Einbringen des elektrooptischen Halbleiterbauelementes gegeneinander. Die Fläche zur Aufnahme des elektroptischen Halbleiterbauelementes verkleinert sich mit kleiner werdendem Abstand zum Formwerkzeug kontinuierlich, wodurch die Einbringung des elektrooptischen Halbleiterbauelementes in die Aufnahmevorrichtungen vereinfacht wird und eine Selbstjustierung des elektrooptischen Halbleiterbauelementes beim Einbringen erfolgt. Dadurch können elektrooptische Halbleiterbauelemente mit größerer Toleranz in den Abmessungen mit minimalem Justagefehler mit dem Wellenleitergraben gekoppelt werden.

Besonders vorteilhaft ist es, die Grundeinheit und einen Lichtwellenleiter mit Hilfe einer Abdeckung, vorzugsweise aus Polymer, fest miteinander zu verbinden, wobei der Wellenleitergraben mit einem Licht leitenden höherbrechenden Material, vorzugsweise mit Polymer, aufgefüllt wird. Die Abdeckung weist für die Justage des Lichtwellenleiters selbstjustierende Aufnahmevorrichtungen auf. Auf diese Weise wird unter Auffüllung des Wellenleitergrabens mit einem Polymer ein Wellenleiter hergestellt. Gleichzeitig wird das Polymer zur Verbindung der Abdeckung mit der Grundeinheit verwendet. Die selbstjustierenden Aufnahmevorrichtungen der Abdeckung vereinfachen die Justage des Lichtwellenleiters in Bezug auf den Wellenleitergraben. Sie sind außerdem dann vorteilhaft, wenn auch die Abdeckung Elemente enthält, die das optische Feld beeinflussen oder detektieren.

Zur besonders einfachen elektrischen Kontaktierung des elektrooptischen Halbleiterbauelementes werden in der Abdeckung Öffnungen vorgesehen oder nachträglich mittels Laserablation erzeugt. Auf diese Weise können Kontakte für hohe Ströme an das elektrooptische Halbleiterbauelement angebracht werden. Alternativ werden zur elektrischen Kontaktierung des elektrooptischen Halbleiterbauelementes Leiterbahnen auf die Polymeroberfläche aufgesputtert oder aufgedampft.

Diese Arten der elektrischen Kontaktierung sind technologisch einfach zu beherrschen, preiswert und mit vielen Herstellungsverfahren kompatibel.

Eine Erweiterung des Verfahrens besteht darin, vorzugsweise als elektrooptische Halbleiterbauelemente Laserdioden, Laserdiodenarrays, Laserdiodenverstärker, Laserdiodenverstärkerarrays, Halbleitermodulatoren, Halbleiterdemodulatorenarrays, Detektoren und Detektorenarrays zu verwenden. Dadurch können unterschiedlich aufgebaute integrierte optische Schaltungen nach dem gleichen Verfahren hergestellt werden.

Eine Erweiterung des Verfahrens besteht darin, im Bereich des elektrooptischen Halbleiterbauelementes ein thermoelektrisches Bauelement so anzubringen, daß der Brechungsindex des Wellenleiters verändert werden kann.

Es ist besonders vorteilhaft, den Wellenleiter als einen lateral stetigen und/oder segmentierten Taper auszubilden. Dies ermöglicht es, bei dem Herstellungsverfahren für die Grundeinheit gleichzeitig einen Taper auszubilden, der den vom elektrooptischen Halbleiterbauelement emittierten Lichtfleck aufweitet und so die Koppelverluste an den Lichtwellenleiter verkleinert. Die Ausbildung des Wellenleiters als lateral stetigen und/oder segmentierten Taper ist mit Hilfe des Abformverfahrens einfach und ohne weiteren Bearbeitungsprozeß preiswert auszuführen.

Eine Verbesserung des Verfahrens besteht darin, die Trägerplatte an eine Wärmesenke, vorzugsweise ein Peltier-Element, anzukoppeln. Damit wird die vom elektrooptischen Halbleiterbauelement erzeugte Wärme abgeführt.

Für eine kompakte Integration einer hybrid integriert optischen Schaltung ist es von Vorteil, wenn die Wärmesenke als Silizium-Platte ausgestaltet ist, auf der elektronische Schaltungsanordnungen aufgebracht sind. Dadurch wird eine höhere Integration erreicht und die Abmessungen des gesamten Bauelementes verkleinert.

### Zeichnung

Ausführungsbeispiele der Erfindung sind in der Zeichnung dargestellt und in der nachfolgenden Beschreibung näher erläutert. Es zeigen Figur 1 ein Abformwerkzeug mit einem elektrooptischen Halbleiterbauelement, Figur 2 eine Grundeinheit, einen Querschnitt der Grundeinheit und eine Abdeckplatte, Figur 3 einen Schnitt durch eine integrierte optische Schaltung, Figur 4 eine Grundeinheit mit einem segmentierten Taper und einen Querschnitt durch den segmentierten Taper und Figur 5 eine integrierte optische Schaltung mit einem thermoelektrischen Bauelement.

### Beschreibung der Ausführungsbeispiele

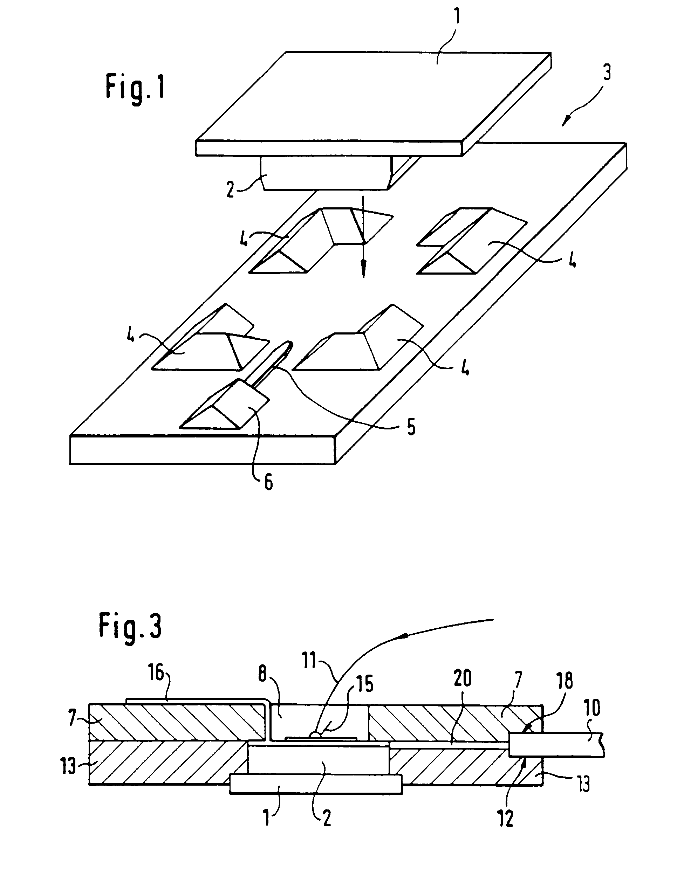

In Figur 1 ist ein elektrooptisches Halbleiterbauelement 2 dargestellt, das auf einer Trägerplatte 1 aufgebracht ist. Weiterhin zeigt Figur 1 ein Abformwerkzeug 3 mit Aufnahmevorrichtungen 4, einer Negativform 5 für einen Wellenleitergraben 9 und einer weiteren Negativform 6 für eine Aufnahmevorrichtung 12 für einen Lichtwellenleiter 10 . Das Abformwerkzeug 3 mit den Aufnahmevorrichtungen 4 und den Negativformen 5,6 besteht vorzugsweise aus einem galvanisch abformbaren Metall, wie z. B. Nickel. Die Aufnahmevorrichtungen 4 und die Negativform 5 des Wellenleitergrabens 9 und die Negativform 6 für die Aufnahmevorrichtung 12 sind zueinander so ausgerichtet, daß bei Einbringung des elektrooptischen Halbleiterbauelementes 2 in die Aufnahmevorrichtungen 4 der Austrittsbereich des vom elektrooptischen Halbleiterbauelement 2 erzeugten Lichtes an den von der Negativform 5 abgeformten Wellenleitergraben 9 optimal justiert angekoppelt ist.

Besonders wichtig ist es, eine seitliche Versetzung der Negativform 5 zum Austrittsbereich des Lichtstrahls zu vermeiden. Deshalb müssen die Aufnahmevorrichtungen 4 mit höchster Genauigkeit die Position des elektrooptischen Halbleiterbauelementes 2 in Querrichtung zur Negativform 5 festlegen.

Dazu muß das elektrooptische Halbleiterbauelement 2 eine definierte Breite mit geringer Toleranz aufweisen. Die Genauigkeit der Justage wird dadurch erhöht, daß diejenigen Seitenwände der Aufnahmevorrichtungen 4 des Abformwerkzeuges 3, die parallel zu der Negativform 5 verlaufen, und die Seitenwände des elektrooptischen Halbleiterbauelementes 2 zumindestens teilweise leicht schräg nach innen verlaufen, so daß sich der Abstand zur Aufnahme des elektrooptischen Halbleiterbauelementes 2 zwischen den Seiten der Aufnahmevorrichtungen 4 mit abnehmendem Abstand zum Abformwerkzeug 3 verkleinert.

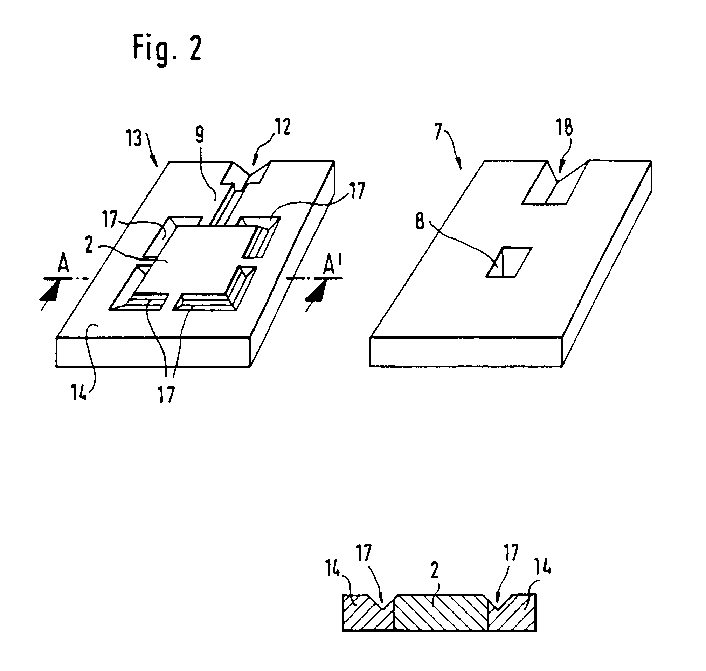

Figur 2 zeigt die Grundeinheit 13, die aus einem elektrooptischen Halbleiterbauelement 2 besteht, das in einem geformten Werkstoff 14 eingebettet ist. Das Abformwerkzeug 3 hat in dem geformten Werkstoff 14 einen Wellenleitergraben 9, Ausnehmungen 17 und eine Aufnahmevorrichtung 12 für einen Lichtwellenleiter 10, die in Bezug auf den Wellenleitergraben 9 selbstjustierend ist, abgeformt. Die Ausnehmungen 17 sind von den Aufnahmevorrichtungen 4 des Abformwerkzeuges 3, die zur Aufnahme und Justierung des eingebrachten elektrooptischen Halbleiterbauelementes 2 in Bezug auf den Wellenleitergraben 9 verwendet werden, in den Werkstoff 14 eingeprägt worden. Der Querschnitt A-A' durch die Grundeinheit 13 zeigt deutlich die Struktur der Ausnehmungen 17 und die Abschrägung der Seitenflächen des elektrooptischen Halbleiterbauelementes 2. Die Ausnehmungen 17 sind so um das elektrooptische Halbleiterbauelement 2 angeordnet, daß die Ausrichtung des elektrooptischen Halbleiterbauelementes 2 auf den Wellenleitergraben 9 festgelegt wird. Der Wellenleitergraben 9 schließt sich an den Licht emittierenden Bereich des elektrooptischen Halbleiterbauelementes 2 an. An den Wellenleitergraben 9 schließt sich die Aufnahmevorrichtung 12 für den Lichtwellenleiter 10 an. Vorzugsweise ist diese Aufnahmevorrichtung 12 als V-Graben ausgestaltet. Durch diese Formgebung wird eine einfache und präzise Justage des Lichtwellenleiters 10 in Bezug auf den Wellenleitergraben 9 erreicht.

Weiterhin ist eine Abdeckung 7 in Figur 2 dargestellt, die vorzugsweise aus dem gleichen Werkstoff wie die Grundeinheit 13 abgeformt wurde. Die Abdeckung 7 weist eine Kontaktöffnung 8 zur elektrischen Kontaktierung des elektrooptischen Halbleiterbauelementes 2 und eine Aufnahmevorrichtung 18 für den Lichtwellenleiter 10 auf. Die Aufnahmevorrichtung 18 der Abdeckung 7 ist zur Aufnahme des Lichtwellenleiters 10 in diesem gewählten Beispiel als V-Graben ausgebildet.

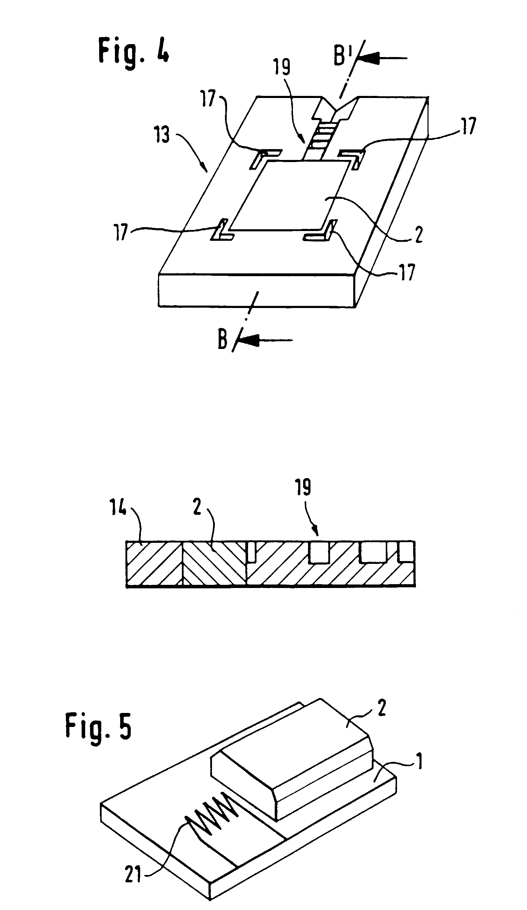

Figur 3 zeigt einen Schnitt durch eine integrierte optische Schaltung, bestehend aus einer Grundeinheit 13, die mit einer Abdeckung 7 fest verbunden ist. Weiterhin ist ein Lichtwellenleiter 10 an den Wellenleiter 20 angekoppelt. Über die Kontaktöffnung 8 ist ein Kontaktdraht 11 an dem elektrooptischen Halbleiterbauelement 2 angebracht. Außerdem kann das elektrooptische Halbleiterbauelement 2 mittels aufgesputterter Leiterbahnen 16, wie in Figur 3 dargestellt, kontaktiert werden. Der Wellenleitergraben 9 ist mit einem optisch transparenten Material mit höherer Brechzahl als der Brechzahl des Werkstoffs 14, vorzugsweise einem Polymer, aufgefüllt und bildet so den Wellenleiter 20. Der Austrittsbereich des Lichtes des elektrooptischen Halbleiterbauelementes 2 ist an den Wellenleiter 20 angekoppelt. Der Lichtwellenleiter 10 ist über die Aufnahmevorrichtungen 12 der Grundeinheit 13 und die Aufnahmevorrichtung 18 der Abdeckung 7 fest mit der integriert optischen Schaltung verbunden und an den Wellenleiter 20 angekoppelt.

Figur 4 zeigt eine Grundeinheit 13, mit einem Wellenleitergraben 9, der als segmentierter Taper ausgebildet ist. Der Querschnitt B-B' zeigt die Struktur des segmentierten Tapers. In diesem Beispiel ist ein zweidimensionaler Taper, wie bei Z.Weissmann," 2-D Mode Tapering Via Tapered Channel Waveguide Segmentation", Electronics Letters, Vol.28, No.16, 1992, S. 1514 ff., beschrieben, dargestellt. Der segmentierte Taper 19 weitet den Durchmesser des vom elektrooptischen Halbleiterbauelement 2 emittierten Lichtstrahls auf. Dadurch werden bei der Einkoppelung des Lichtstrahls in den Lichtwellenleiter 10 die Kopplungsverluste aufgrund der besseren Anpassung des Fleckdurchmessers reduziert. Vorzugsweise kann der Wellenleitergraben 9 auch als dreidimensionaler Taper ausgebildet werden.

Figur 5 zeigt eine Trägerplatte 1, die außer einem elektrooptischen Halbleiterbauelement 2 ein thermoelektrisches Bauelement 21 trägt. Das thermoelektrische Bauelement 21 wird auf gleiche Weise wie das elektrooptische Halbleiterbauelement 2 in einer Grundeinheit 13 eingebettet. Mit dem thermoelektrischen Bauelement 21 kann der Brechungsindex eines oder mehrerer Wellenleiter 20, die in der Nähe des thermoelektrischen Bauelementes 21 verlaufen, verändert werden.

Das verwendete Verfahren wird anhand der Figuren 1 bis 5 näher erläutert. Zur Herstellung der Grundeinheit 13 wird das elektrooptische Halbleiterbauelement 2, das auf einer Trägerplatte 1 montiert ist, in die Aufnahmevorrichtungen 4 des Abformwerkzeuges 3 eingbracht. Dabei wird das elektrooptische Halbleiterbauelement 2 durch die Form und Ausrichtung der Aufnahmevorrichtungen 4 in Bezug auf die Negativform 5 des Wellenleitergrabens 9 justiert, so daß seitliche Versetzungen und Verkippungen verhindert werden. Danach wird das Abformwerkzeug 3 und das eingebrachte elektrooptische Halbleiterbauelement 2 mit der Trägerplatte 1 mit einem formbaren Werkstoff umgossen. Vorzugsweise ist der verwendete Werkstoff ein Polymer. Die Verwendung des Abformwerkzeuges 3 mit den Negativformen 5,6 für einen Wellenleitergraben 9 und Aufnahmevorrichtungen 12 für den Lichtwellenleiter 10 ermöglichen ein einfaches Abformen durch Spritzguß-, Spritzpräge- oder Gießverfahren, wobei vorzugsweise polymere Kunststoffe verwendet werden.

Die Aufnahmevorrichtungen 4 des Abformwerkzeuges 3 können vorzugsweise so ausgebildet sein, daß Laserdioden, Laserdiodenarrays, Laserdiodenverstärker, Laserdiodenverstärkerarrays, Halbleitermodulatoren,Halbleiterdemodulatoren, Detektoren und Detektorenarrays in Bezug auf den Wellenleiter 20 selbstjustierend optisch angekoppelt werden.

Durch dieses Verfahren wird ein hybrider Einbau von elektrooptischen Halbleiterbauelementen 2 in polymere, integriert optische Schaltungen durch Verwendung eines Selbstjustierungsverfahren ermöglicht. Nach Abnahme des Abformwerkzeuges 3 liegt eine Grundeinheit 13 vor, die aus einem elektrooptischen Halbleiterbauelement 2 und einem geformten Werkstoff 14 besteht. In diesem gewählten Beispiel sind in den polymeren Kunststoff ein Wellenleitergraben 9 und eine Aufnahmevorrichtung 12 durch Abformen des Abformwerkzeuges 3 eingebracht worden. Wie in Figur 3 dargestellt, wird in diesem Ausführungsbeispiel als Lichtwellenleiter 10 eine Lichtleitfaser oder ein Lichtleitfaserbündel an den Wellenleiter 20 angekoppelt.

Zur Abdeckung des elektrooptischen Halbleiterbauelementes 2 und des Wellenleitergrabens 9 wird eine Abdeckung 7 verwendet, die beispielsweise mit einem Abformwerkzeug aus polymerem Kunststoff hergestellt werden kann. Die für dieses Beispiel gewählte Abdeckung 7 verfügt über eine Kontaktöffnung 8, die zur elektrischen Kontaktierung des elektrooptischen Halbleiterbauelementes 2 verwendet wird, und eine Aufnahmevorrichtung 18, die zur Justierung und zur Befestigung des Lichtwellenleiters 10 verwendet wird. Zur Herstellung der integriert optischen Schaltung wird der Lichtwellenleiter 10 in die Aufnahmevorrichtung 12 der Grundeinheit 13 eingelegt. Ein optisch transparenter Klebstoff, vorzugsweise ein polymerer Kunststoff, wird auf die Grundeinheit 13 unter Auffüllung des Wellenleitergrabens 9 und der Ausnehmungen 17 aufgebracht. Durch die Auffüllung des Wellenleitergrabens 9 mit einem optisch transparenten Material mit höherem Brechungsindex als der des Werkstoffs 14 wird aus dem Wellenleitergraben 9 ein Wellenleiter 20. Die Abdeckung 7 wird auf die Grundeinheit 13 gelegt, so daß der Lichtwellenleiter 10 von der Aufnahmevorrichtung 18 der Abdeckung 7 und der Aufnahmevorrichtung 12 der Grundeinheit 13 an den Wellenleiter 20 selbstjustierend angekoppelt wird. Die Abdeckung 7 wird gegen die Grundeinheit 13 gepreßt, so daß sich außerhalb des Wellenleitergrabens 9 nur eine dünne Schicht des polymeren Kunststoffes zwischen der Grundeinheit 13 und der Abdeckung 7 befindet, die nach dem Aushärten des polymeren Kunststoffes die Verbindung zwischen der Grundeinheit 13 und der Abdeckung 7 herstellt.

Zur elektrischen Kontaktierung wird, wie in Figur 3 dargestellt, ein Kontaktdraht 11 über die Kontaktöffnung 8 an das elektrooptische Halbleiterbauelement 2 gebondet. Bei Verwendung einer Abdeckung, die keine Kontaktöffnung 8 aufweist, kann die zur elektrischen Kontaktierung notwendige Öffnung mittels Laserablation nachträglich in die Abdeckung 7 eingebracht werden. Vorzugsweise kann eine Leiterbahn 16 zur elektrischen Kontaktierung des elektrooptischen Halbleiterbauelementes 2 aufgesputtert oder aufgedampft werden. Die Herstellung des Abformwerkzeuges 3 in verschiedenen Formen ermöglicht es, nicht nur ein bestimmtes elektrooptisches Halbleiterbauelement 2, sondern unterschiedliche elektrooptische Halbleiterbauelemente wie z.B. Laserdioden, Laserdiodenarrays, Laserdiodenverstärker, Laserdiodenverstärkerarrays, Halbleitermodulatoren,Halbleiterdemodulatoren, Detektoren und Detektorenarrays gleichzeitig mit einem polymeren Kunststoff zu umformen und in eine Grundeinheit einzubetten. Weiterhin bietet die Abformung des Wellenleitergrabens 9 die Möglichkeit einen segmentierten Taper 19, wie in Figur 4 dargestellt, auf einfache Art und Weise in einem Verfahrensschritt mit der Herstellung der Grundeinheit 13 auszubilden.

Die Herstellung des segmentierten Tapers 19 erfolgt, indem die nach der Abformung der Grundeinheit verbleibenden Leerräume des Wellenleitergrabens 9, die in Figur 4 dargestellt sind, mit einem Polymer aufgefüllt werden. Das Polymer, das in die Leerräume eingefüllt wird, besitzt einen im Vergleich zum polymeren Kunststoff, aus dem die Grundeinheit 13 geformt wurde, höheren Brechungsindex.

Da die aktive Zone des elektrooptischen Halbleiterbauelementes 2, die wie im Fall einer Laserdiode das Laserlicht erzeugt, beim Einbringen des elektrooptischen Halbleiterbauelementes 2 nicht beschädigt werden darf, ist es vorteilhaft, auf dem Abformwerkzeug 3 Abstandshalter anzubringen, die eine Beschädigung der aktive Zone verhindern. Die Trägerplatte 1 dient als Wärmesenke und kann vorzugsweise an ein Peltier-Element angekoppelt sein.

Weiterhin kann als Trägerplatte 1 eine Silizium-Platte mit elektronischen Schaltungsanordnungen verwendet werden. Die auf die Abdeckung 7 aufgedampften bzw. aufgesputterten Leiterbahnen 16 sind entsprechend dick aufzubringen, damit die für den Betrieb des elektrooptischen Halbleiterbauelementes 2 notwendigen Stromstärken ohne Erwärmung der Leiterbahnen 16 zugeführt werden können.

## Patentansprüche

1. Verfahren zur Herstellung einer hybrid integrierten optischen Schaltung mit mindestens einem elektrooptischen Halbleiterbauelement und einem Lichtwellenleiter, in dem
ein Abformwerkzeug (3) mit Aufnahmevorrichtungen (4) für mindestens ein elektrooptisches Halbleiterbauelement (2) und mit mindestens einer Negativform (6) für eine Aufnahmevorrichtung (12) für einen Lichtwellenleiter (10) und mit mindestens einer Negativform (5) für einen Wellenleitergraben (9) verwendet wird,
das elektrooptische Halbleiterbauelement (2), das vorzugsweise auf einer Trägerplatte (1) befestigt ist, in die Aufnahmevorrichtungen (4) des Abformwerkzeuges (3) eingefügt wird,
daraufhin das Abformwerkzeug (3) und das elektrooptische Halbleiterbauelement (2) mit einem Werkstoff, vorzugsweise einem Polymer, derart umformt werden,
daß nach Abnahme des Abformwerkzeuges (3) das elektrooptische Halbleiterbauelement (2) und der geformte Werkstoff (14) eine Grundeinheit (13) mit mindestens einem in Bezug auf das elektrooptische Halbleiterbauelement (2) justierten Wellenleitergraben (9) und mit in Bezug auf das elektrooptische Halbleiterbauelement (2) oder in bezug auf den Wellenleitergraben (9) selbstjustierenden Aufnahmevorrichtungen (12) für mindestens einen Lichtwellenleiter (10), der vorzugsweise als Lichtleitfaser oder Lichtleitfaserbündel ausgebildet ist, darstellt.

2. Verfahren nach Anspruch 1, in dem die Seitenwände der Aufnahmevorrichtungen (4) des Abformwerkzeuges (3), die den Raum für das aufzunehmende elektrooptische Halbleiterbauelement (2) begrenzen, und die Seitenwände des elektrooptischen Halbleiterbauelementes (2) zumindest teilweise nach innen geneigt sind.

3. Verfahren nach einem der Ansprüche 1 bis 2, in dem die Grundeinheit (13) und der Lichtwellenleiter (10) mithilfe einer Abdeckung (7), vorzugsweise aus Polymer, fest miteinander verbunden werden, wobei der Wellenleitergraben (9) mit einem optisch transparenten Material, vorzugsweise mit Polymer, aufgefüllt wird, daß die Abdeckung (7) für die Justage des Lichtwellenleiters (10) selbstjustierende Aufnahmevorrichtungen (18) aufweist.

4. Verfahren nach einem der Ansprüche 1 bis 3, in dem zur Anbringung von elektrischen Kontakten (15) an das elektrooptische Halbleiterbauelement (2) bei der Abformung der Grundeinheit (13) und/oder der Abdeckung (7) Öffnungen (8) vorgesehen werden oder mittels Laserablation erzeugt werden.

5. Verfahren nach einem der Ansprüche 1 bis 4, in dem, daß zur elektrischen Kontaktierung des elektrooptischen Halbleiterbauelements (2) Leiterbahnen (16) aufgesputtert, aufgedampft oder Leitungsdrähte (11) angebondet werden.

6. Verfahren nach einem der Ansprüche 1 bis 5, in dem, daß das elektrooptische Halbleiterbauelement (2) als Laserdiode, Laserdiodenarray, Laserdiodenverstärker, Laserdiodenverstärkerarray, Halbleitermodulator, Halbleitermodulatorarray, Detektor, Detektorarray ausgeführt wird.

7. Verfahren nach einem der Ansprüche 1 bis 6, in dem, daß neben dem elektrooptischen Halbleiterbauelement (2) ein thermoelektrisches Bauelement (21), vorzugsweise eine Thermosonde, so angeordnet ist, daß der Brechungsindex des Wellenleiters (20) durch das thermoelektrische Bauelement (21) verändert werden kann.

8. Verfahren nach einem der Ansprüche 1 bis 7, in dem daß der Wellenleitergraben (9) als ein lateraler stetiger und/oder segmentierter Taper ausgebildet ist.

9. Verfahren nach einem der Ansprüche 1 bis 8, in dem daß die Trägerplatte (1) eine Wärmesenke darstellt, die vorzugsweise an ein Peltier-Element angekoppelt ist.

10. Verfahren nach einem der Ansprüche 1 bis 9 in dem daß als Trägerplatte eine Siliziumplatte verwendet wird, auf der elektronische Schaltungsanordnungen aufgebracht sind.

11. Vorrichtung zur Emission von Lichtwellen mit einem elektrooptischen Halbleiterbauelement, die im wesentlichen als Platte aus einem Polymerwerkstoff ausgebildet ist, wobei die Platte das elektrooptische Halbleiterbauelement (2) umformt, wobei der geformte Polymerwerkstoff (14) erste Ausnehmungen (17) aufweist, die entlang den Seiten des elektrooptischen Halbleiterbauelements (2) angeordnet sind und der geformte Polymerwerkstoff (14) mindestens eine an die lichtemittierende Zone des elektrooptischen Halbleiterbauelementes (2) angrenzende zweite Ausnehmung (1, 12) aufweist, wobei die zweite Ausnehmung als Wellenleitergraben (9) mit einer anschließenden Aufnahmevorrichtung (12) für einen Lichtwellenleiter (10) ausgebildet ist.

12. Vorrichtung nach Anspruch 11, wobei das mit dem Werkstoff umformte elektrooptische Halbleiterbauelement (2) mit einer Abdeckung (7) verbunden ist, die Abdeckung (7) mindestens eine Aufnahmevorrichtung (18) für einen Lichtwellenleiter (10) aufweist und der Wellenleitergraben (9) mit einem optisch transparenten Material aufgefüllt ist und so einen Wellenleiter (20) bildet, wobei ein Lichtwellenleiter (10) an den Wellenleiter (20) optisch angekoppelt ist.

## Claims

1. Method for producing a hybrid integrated optical circuit having at least one electrooptic semiconductor component and one optical waveguide, in which use is made of a moulding tool (3) having holding devices (4) for at least one electrooptic semiconductor component (2) and having at least one negative mould (6) for a holding device (12) for an optical waveguide (10) and having at least one negative mould (5) for a waveguide trench (9), the electrooptic semiconductor component (2), which is preferably mounted on a carrier plate (1), is inserted into the holding devices (4) of the moulding tool (3) whereupon the moulding tool (3) and the electrooptic semiconductor component (2) are reshaped by means of a material, preferably a polymer, in such a fashion that after removal of the moulding tool (3) the electrooptical semiconductor component (2) and the moulded material (14) represent a basic unit (13) having at least one waveguide trench (9) adjusted with respect to the electrooptic semiconductor component (2) and having holding devices (12), which are self-adjusting with respect to the electrooptic semiconductor component (2) or with respect to the waveguide trench (9), for at least one optical waveguide (10) which is preferably constructed as an optical fibre or optical fibre bundle.

2. Method according to Claim 1, in which the side walls of the holding devices (4) of the moulding tool (3), which bound the space for the electrooptic semiconductor component (2) to be accommodated, and the side walls of the electrooptic semiconductor component (2) are inclined inwards at least partially.

3. Method according to one of Claims 1 to 2, in which the basic unit (13) and the optical waveguide (10) are permanently connected to one another with the aid of a cover (7), preferably made from polymer, the waveguide trench (9) being filled with an optically transparent material, preferably with polymer, and the cover (7) has self-adjusting holding devices (18) for adjusting the optical waveguide (10).

4. Method according to one of Claims 1 to 3, in which openings (8) are provided or produced by means of laser ablation for the purpose of attaching electrical contacts (15) to the electrooptic semiconductor component (2) when moulding the basic unit (13) and/or the cover (7).

5. Method according to one of Claims 1 to 4, in which conductor tracks (16) are sputtered on or vapour deposited or conducting wires (11) are bonded on for the purpose of electrical contacting of the electrooptic semiconductor component (2).

6. Method according to one of Claims 1 to 5, in which the electrooptic semiconductor component (2) is designed as a laser diode, laser diode array, laser diode amplifier, laser diode amplifier array, semiconductor modulator, semiconductor demodulator array, detector or detector array.

7. Method according to one of Claims 1 to 6, in which in addition to the electrooptic semiconductor component (2) a thermoelectric component (21), preferably a thermal probe, is arranged in such a way that the refractive index of the waveguide (20) can be varied by the thermoelectric component (21).

8. Method according to one of Claims 1 to 7, in which the waveguide trench (9) is constructed as a lateral continuous and/or segmented taper.

9. Method according to one of Claims 1 to 8, in which the carrier plate (1) represents a heat sink which is preferably coupled to a Peltier element.

10. Method according to one of Claims 1 to 9, in which use is made as carrier plate of a silicon plate to which electronic circuit arrangements are applied.

11. Device for emitting light waves, having an electrooptic semiconductor component, which is essentially constructed as a plate made from a polymer material, the plate reshaping the electrooptic semiconductor component (2), the moulded polymer material (14) having first recesses (17) which are arranged along the sides of the electrooptic semiconductor component (2) and the moulded polymer material (14) having at least one second recess (1, 12) bordering on the light-emitting zone of the electrooptic semiconductor component (2), the second recess being constructed as a waveguide trench (9) having an adjoining holding device (12) for an optical waveguide (10).

12. Device according to Claim 11, the electrooptic semiconductor component (2) reshaped with the material being connected to a cover (7), the cover (7) having at least one holding device (18) for an optical waveguide (10), and the waveguide trench (9) being filled with an optically transparent material and thus forming a waveguide (20), an optical waveguide (10) being optically coupled to the waveguide (20).

## Revendications

1. Procédé de réalisation d'un circuit optique intégré hybride ayant au moins un composant semi-conducteur optoélectronique et un guide de lumière, dans lequel :
• on utilise un outil de moulage (3) muni de dispositifs de réception (4) pour au moins un composant semi-conducteur optoélectronique (2), au moins un moule négatif (6) pour un dispositif de réception (12) d'un guide de lumière (10), et au moins un moule négatif (5) pour un sillon de guide d'ondes (9),
• on fixe le composant semi-conducteur électro-optique (2) de préférence sur une plaque de support (1) dans laquelle on ajoute les dispositifs de réception (4) de l'outil de moulage (3),
• puis on entoure l'outil de moulage (3) et le composant semi-conducteur optoélectronique (2) avec une matière moulée (14) de préférence un polymère, pour qu'après enlèvement de l'outil de moulage (3), le composant semi-conducteur optoélectronique (2) et la matière moulée (14) forment une unité de base (13) avec au moins un sillon à guide de lumière (9) ajusté sur le composant semi-conducteur optoélectronique (2) et au moins des dispositifs de réception (12) auto-ajustés par rapport au composant semi-conducteur optoélectronique (2) ou par rapport au sillon (9) du guide d'ondes, pour au moins un guide de lumière (10) constitué de préférence par des fibres optiques ou des faisceaux de fibres de lumière.

2. Procédé selon la revendication 1,
caractérisé en ce que
les parois latérales du dispositif de réception (4) de l'outil de moulage (3) qui délimitent l'espace pour recevoir le composant semi-conducteur optoélectronique (2), et les parois latérales du composant semi-conducteur optoélectronique (2), sont au moins partiellement inclinées vers l'intérieur.

3. Procédé selon l'une des revendications 1 et 2,
caractérisé en ce que
l'unité de base (13) et le guide de lumière (10) sont reliés solidairement par l'intermédiaire d'un couvercle (7) de préférence en polymère, les sillons (9) des guides de lumière sont remplis d'une matière, de préférence un polymère plus transparent optiquement, et le couvercle (7) comporte des dispositifs de réception (18) auto-ajustés pour ajuster le guide de lumière (10).

4. Procédé selon l'une des revendications 1 à 3,
caractérisé en ce que
pour mettre en place des contacts électriques (15) sur le composant semi-conducteur optoélectronique (2), au moment du moulage de l'unité de base (13) et/ou du couvercle (7), on réalise des ouvertures (8) ou on le forme par ablation par laser.

5. Procédé selon l'une des revendications 1 à 4,
caractérisé en ce que
l'on réalise des chemins conducteurs (16) par pulvérisation, par dépôt de vapeur ou par des fils conducteurs (11), fixés, pour assurer la mise en contact électrique du composant semi-conducteur optoélectronique (2).

6. Procédé selon l'une des revendications 1 à 5,
caractérisé en ce que
le composant semi-conducteur optoélectronique (2) est une diode laser, un réseau de diodes laser, un amplificateur à diodes laser, un réseau d'amplificateurs à diodes laser, un modulateur semi-conducteur, un réseau de modulateurs semi-conducteurs, un détecteur, un réseau de détecteurs.

7. Procédé selon l'une des revendications 1 à 6,
caractérisé en ce qu'
en plus du composant semi-conducteur optoélectronique (2), on prévoit un composant thermoélectrique (21), de préférence une thermosonde et on modifie l'indice de réfraction du composant de lumière (20) par le composant thermoélectrique (21).

8. Procédé selon l'une des revendications 1 à 7,
caractérisé en ce que
le sillon (9) pour le guide d'ondes est réalisé sous la forme d'une répartition latérale constante et/ou segmentée.

9. Procédé selon l'une des revendications 1 à 8,
caractérisé en ce que
la plaque de support (1) est un puits de chaleur couplé de préférence à un élément à effet Peltier.

10. Procédé selon l'une des revendications 1 à 9,
caractérisé en ce que
la plaque de support est une plaque de silicium portant des circuits électroniques.

11. Dispositif pour émettre des ondes lumineuses, comprenant un composant semi-conducteur optoélectronique réalisé de préférence par une plaque en une matière polymère, la plaque entourant le composant semi-conducteur optoélectronique (2), la matière polymérisable (14) comportant une première cavité (17) prévue le long des côtés des composants semi-conducteurs électroniques (2), la matière polymérisée (14), mise en forme, comportant au moins une seconde cavité (1, 12) adjacente à la zone d'émission lumineuse du composant semi-conducteur optoélectronique (2), et la seconde cavité étant un sillon de guide d'ondes (9) suivi directement par un dispositif de réception (12) pour un guide d'ondes (10).

12. Dispositif selon la revendication 11,
caractérisé en ce que
le composant semi-conducteur optoélectronique (12) entouré de matière est relié à un couvercle (7) et ce dernier comporte au moins un dispositif de réception (18) pour un guide de lumière, le sillon (9) du guide d'ondes étant rempli d'une matière optiquement transparente formant le guide d'ondes (20), auquel est couplé optiquement un guide de lumière (10).
